# EUROPEAN PATENT APPLICATION

(11) **EP 3 258 353 A1**
(43) Date of publication of application: **20.12.2017**
(21) Application number: 16749377.4
(22) Date of filing: 29.01.2016
(51) Int. Cl.: G06F 3/041, G06F 3/044, G06F 3/046, G02F 1/1333, H01L 27/32

(54) **DISPLAY MODULE CAPABLE OF DETECTING LOCATION USING ELECTROMAGNETIC INDUCTION AND CAPACITANCE METHODS, AND DISPLAY DEVICE HAVING SAME**

(30) Priority: 12.02.2015 KR 20150021360
(71) Applicant: The Han Inc., Geumcheon-gu, Seoul 08504 (KR)
(72) Inventor: KIM, Sae Young, Seoul 08504 (KR); AHN, Sang Sup, Seoul 08504 (KR)
(74) Representative: Groth & Co. KB
(86) International application number: PCT/KR2016/000977
(87) International publication number: WO 2016/129837

(57) **Abstract**

There are provided a display module capable of detecting a locating using capacitance and electromagnetic induction methods and a display device including the same. The display module capable of detecting a locating using capacitance and electromagnetic induction methods according to an embodiment of the present invention includes a display device; and a location detecting unit which is integrally provided in the display device and detects a touch location from a change in capacitance due to a touch operation and detects a location of an electronic pen from a change in inductive electromagnetic field due to electromagnetic induction.

## Description

### [TECHNICAL FIELD]

The present invention relates to a display module capable of detection a location using an electromagnetic induction method and a display device including the same, and more particularly, to a display module capable of detection a location using capacitance and electromagnetic induction methods capable of detecting a touch location due to a touch operation and a location of an electronic pen due to electromagnetic induction, and a display device including the same.

### [BACKGROUND ART]

A touch panel is widely used as an input device in a display device including a mobile communication terminal, a PDA, a tablet PC, and the like.

In a display device in the related art, the touch panel is used to be separately configured on or below a display device including an organic light emitting diode (OLED), a liquid crystal display (LCD), an active matrix organic light emitting diode (AMOLED), a field emission display (FED), and the like.

Meanwhile, recently, input devices capable of detecting both a touch by the finger and a touch by the electronic pen, particularly, both an input using a capacitance method and an input using an electromagnetic induction method for detecting the location of the electronic pen emitting an induced electromagnetic field have been developed.

The capacitance method is a method in which a transparent electrode pattern is formed on a capacitive touch sensor substrate with a transparent conductive material such as indium tin oxide (ITO), metal mesh, Ag nano wire or CNT, and a flexible circuit board connected to the outside is electrically connected to the transparent electrode pattern.

In addition, the input using the electromagnetic induction method may be variously provided, for example, when a battery is built in the electronic pen or when the battery is not built in.

When the battery is not built in the electronic pen, a resonance circuit connected to a capacitor and a coil provided in the electronic pen is resonated by a resonance circuit connected to a capacitor and a coil provided in the input device to transmit energy.

In addition, the input device senses the energy transmitted from the electronic pen to detect the location of the electronic pen.

However, in a conventional display device, a touch panel for detecting a touch location due to a touch operation of a finger separately configured from a display device and a digitizer panel for detecting a location of the electronic pen emitting an induced electromagnetic field are combined.

As a result, the conventional display device has a problem in that the thickness thereof is relatively increased. In addition, since the touch panel for detecting the touch location due to the touch operation of the finger separately configured from the display device and the digitizer panel for detecting the location of the electronic pen emitting the induced electromagnetic field need to be separately manufactured and combined to each other, there is a problem in that the efficiency of the operation is reduced in manufacturing the display device.

Therefore, studies for integrating a coordinate input sensor capable of simultaneously detecting the touch location due to the touch operation and the location of the electronic pen in the display device are required.

### [DISCLOSURE]

### [TECHNICAL PROBLEM]

The present invention has been made in an effort to provides a display module capable of detecting a locating using capacitance and electromagnetic induction methods and a display device including the same, in which a location detecting unit that detects a touch location from a capacitance change due to a touch operation and a location of an electronic pen from a change in an electromagnetic field due to electromagnetic induction is integrated in the display device.

### [TECHNICAL SOLUTION]

An aspect of the present invention provides a display module capable of detecting a location using capacitance and electromagnetic induction methods, the display module comprising: a display device; and a location detecting unit which is integrally provided in the display device and detects a touch location from a change in capacitance due to a touch operation and detects a location of an electronic pen from a change in inductive electromagnetic field due to electromagnetic induction.

The location detecting unit may include a base loop that surrounds at least a part of a sensing area; a plurality of first conductive patterns which is elongated in a first direction in the sensing area and parallel to each other in a second direction crossing the first direction; a plurality of second conductive patterns which are elongated in the second direction in the sensing area and parallel to each other in the first direction to detect a touch location from a capacitance change due to a touch operation by making pairs with the first conductive patterns; and a plurality of third conductive patterns which are elongated in the second direction in the sensing area, connected to the base loop, and parallel to each other in the first direction to detect a location of the electronic pen from the change in the induced electromagnetic field generated as the electronic pen emitting electromagnetic force is approached by making pairs with the first conductive patterns.

The second conductive patterns and the third conductive patterns may be formed on one surface of the substrate disposed in the display device in parallel in the first direction, the first conductive patterns may be formed on one surface of the substrate in parallel in the second direction and cross the second conductive patterns and the third conductive patterns, and the first conductive patterns may be formed on one surface of the substrate by connecting a plurality of unit conductive patterns formed in the first direction between the second conductive patterns and the third conductive patterns by a bridge, or the second conductive patterns and the third conductive patterns are formed on one surface of the substrate by connecting a plurality of unit conductive patterns formed between the first conductive patterns in the second direction by a bridge.

The second conductive patterns and the third conductive patterns may be formed on one surface of the substrate disposed in the display device in parallel in the first direction, and the first conductive patterns may be formed on the other surface of the substrate in parallel in the second direction.

The first conductive patterns, the second conductive patterns, the third conductive patterns, and the base loop may be formed on one surface or the other surface of at least one of a backlight unit a bottom polarizer, a TFT glass substrate, a filter glass substrate, a top polarizer, and a cover glass configuring a liquid crystal display (LCD) device or formed on one surface or the other surface of at least one of a TFT glass substrate, a polarizer, and a cover glass configuring an organic light emitting diodes(OLED) device.

The display module may further include a capacitance controller which connects one ends of the first conductive patterns to the other ends or opens the other ends of the first conductive patterns and applies a signal to at least one of one ends and the other ends of the first conductive patterns to detect the signal shown in the second conductive patterns, or connects one ends of the second conductive patterns to the other ends or opens the other ends of the second conductive patterns and applies a signal to at least one of one ends and the other ends of the second conductive patterns to detect the signal shown in the first conductive patterns, while the first conductive patterns and the second conductive patterns are disconnected from the base loop; and an electromagnetic induction controller which detects a transmission location of an induced electromagnetic field in the second direction based on a signal output from one ends of the first conductive patterns and detects a transmission location of an induced electromagnetic field in the first direction based on a signal output from one ends of the third conductive patterns, while the first conductive patterns and the third conductive patterns are connected with the base loop, in which in the case of detecting the transmission location of the induced electromagnetic field, one ends of the first conductive patterns and the third conductive patterns may be connected to the electromagnetic induction controller and the other ends thereof are connected to the base loop.

The electromagnetic induction controller may detect a location of the electronic pen in the second direction based on the signal output from one ends of at least two first conductive patterns and detect the location of the electronic pen in the first direction based on the signal output from one ends of at least two third conductive patterns.

The location detecting unit may include a base loop that surrounds at least a part of a sensing area; a plurality of first conductive patterns which is elongated in a first direction in the sensing area and parallel to each other in a second direction crossing the first direction; and a plurality of second conductive patterns which is elongated in a second direction in the sensing area and parallel to each other in the first direction, in which the first conductive patterns and the second conductive patterns may make pairs to detect a touch location from a capacitance change due to a touch operation while the first conductive patterns and the second conductive patterns are disconnected from the base loop, and the first conductive patterns and the second conductive patterns may make pairs to detect the location of the electronic pen from a change in an induced electromagnetic field generated as the electronic pen emitting electromagnetic force is approached, while the first conductive patterns and the second conductive patterns are connected with the base loop.

The second conductive patterns may be formed on one surface of the substrate disposed in the display device in parallel in the first direction, the first conductive patterns may be formed on one surface of the substrate in parallel in the second direction and cross the second conductive patterns, and the first conductive patterns may be formed on one surface of the substrate by connecting a plurality of unit conductive patterns formed in the first direction between the second conductive patterns by a bridge, or the second conductive patterns may be formed on one surface of the substrate by connecting a plurality of unit conductive patterns formed between the first conductive patterns in the second direction by a bridge, so that the first conductive patterns and the second conductive patterns are insulated from each other.

The second conductive patterns may be formed on the one surface of the substrate configuring the upper surface of the display device in parallel in the first direction, and the first conductive patterns may be formed on the other surface of the substrate in parallel in the second direction.

The first conductive patterns, the second conductive patterns, and the base loop may be formed on one surface or the other surface of at least one of a backlight unit a bottom polarizer, a TFT glass substrate, a filter glass substrate, a top polarizer, and a cover glass configuring a liquid crystal display (LCD) device or formed on one surface or the other surface of at least one of a TFT glass substrate, a polarizer, and a cover glass configuring an organic light emitting diodes(OLED) device.

The display module may further include a capacitance controller which connects one ends of the first conductive patterns to the other ends or opens the other ends of the first conductive patterns and applies a signal to at least one of one ends and the other ends of the first conductive patterns to detect the signal shown in the second conductive patterns, or connects one ends of the second conductive patterns to the other ends or opens the other ends of the second conductive patterns and applies a signal to at least one of one ends and the other ends of the second conductive patterns to detect the signal shown in the first conductive patterns, while the first conductive patterns and the second conductive patterns are disconnected from the base loop; and an electromagnetic induction controller which detects a transmission location of an induced electromagnetic field in the second direction based on a signal output from one ends of the first conductive patterns and detects a transmission location of an induced electromagnetic field in the first direction based on a signal output from one ends of the second conductive patterns, while the first conductive patterns and the second conductive patterns are connected with the base loop, in which in the case of detecting the transmission location of the induced electromagnetic field, one ends of the first conductive patterns and the second conductive patterns may be connected to the electromagnetic induction controller and the other ends thereof may be connected to the base loop.

The electromagnetic induction controller may detect a location of the electronic pen in the second direction based on the signal output from one ends of at least two first conductive patterns and detect the location of the electronic pen in the first direction based on the signal output from one ends of at least two second conductive patterns.

The display module may further include an energy supply unit which is integrally provided in the display device and supplies energy to the electronic pen by applying a frequency corresponding to a resonance frequency having a resonance circuit of the electronic pen.

The base loop may be disposed at one edge or the other edge of the substrate disposed in the display device to surround at least a part of the sensing area.

Another aspect of the present invention provides a display device including: a case frame; and a display module which is embedded in the case frame, visually displays an image, and detects a touch location from a capacitance change due to a touch operation and a location of an electronic pen from a change in an induced electromagnetic field due to electromagnetic induction.

### [ADVANTAGEOUS EFFECTS]

According to the embodiments of the present invention, the location detecting unit that detects the touch location from the capacitance change due to the touch operation and the location of the electronic pen from the change in the electromagnetic field due to the electromagnetic induction is integrated in the display device, thereby detecting the touch location due to the touch operation and the location of the electronic pen while the display module displays the image and minimizing the thickness of the display module.

### [DESCRIPTION OF DRAWINGS]

FIG. 1 is an exploded perspective view illustrating a display device according to a first embodiment of the present invention.
FIGS. 2A and 2B are schematic views for describing detecting a touch location using a capacitance method.
FIG. 3 is a schematic view for describing detecting a location of an electronic pen using an electromagnetic induction method.
FIGS. 4A and 4B are schematic views for describing detecting a location of an electronic pen using an electromagnetic induction method according to an embodiment when a plurality of line antennas is provided.
FIGS. 5A and 5B are schematic views for describing detecting a location of an electronic pen using an electromagnetic induction method according to another embodiment when a plurality of line antennas is provided.
FIGS. 6 and 7 are plan views illustrating a structure of a location detecting unit according to a first embodiment of the present invention.
FIG. 8 is a cross-sectional view illustrating a display module in which the location detecting unit is integrally provided in an LCD according to the first embodiment of the present invention.
FIGS. 9 and 10 are cross-sectional views illustrating the location detecting unit which is formed on a filter glass substrate of the LCD according to the first embodiment of the present invention, as cross-sectional views taken along line A-A.
FIG. 11 is a cross-sectional view illustrating a display module in which the location detecting unit is integrally provided in an OLED according to the first embodiment of the present invention.
FIGS. 12 and 13 are plan views illustrating a structure of a location detecting unit according to a second embodiment of the present invention.
FIGS. 14 and 15 are cross-sectional views illustrating the location detecting unit which is formed on a filter glass substrate of the LCD according to the first embodiment of the present invention, as cross-sectional views taken along line B-B.

### [MODES OF THE INVENTION]

In order to fully understand the present invention, operational advantages of the present invention and objects achieved by implementing the present invention, the prevent invention will be described with reference to the accompanying drawings which illustrate preferred embodiments of the present invention and the contents illustrated in the accompanying drawings.

Hereinafter, preferred embodiments of the present invention will be described in detail with reference to the accompanying drawings. Like reference numerals illustrated in the respective drawings designate like members.

First, a display device according to a first embodiment of the present invention will be described as follows.

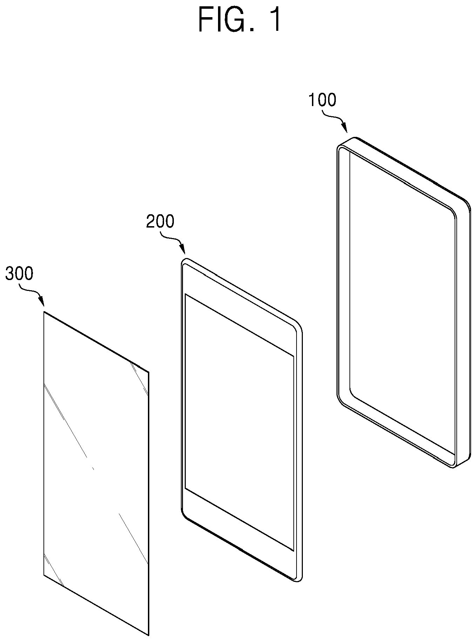

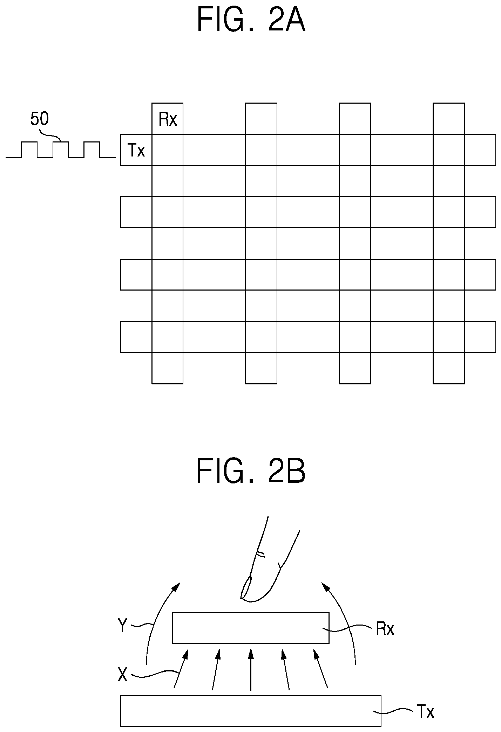

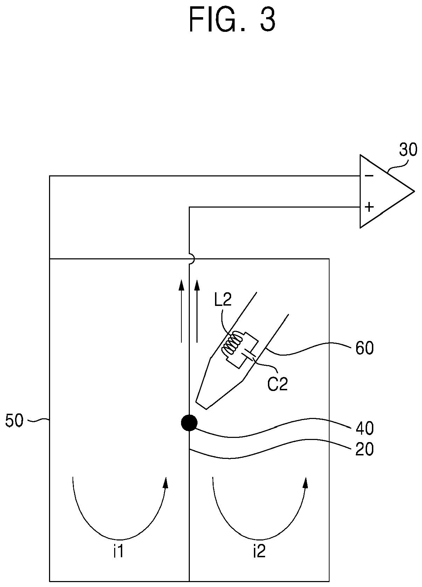

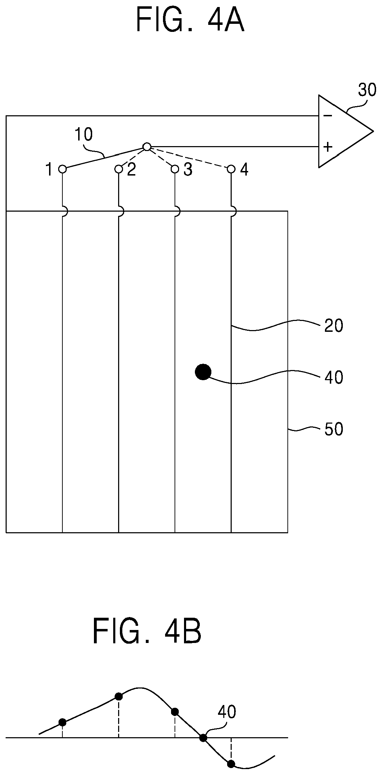

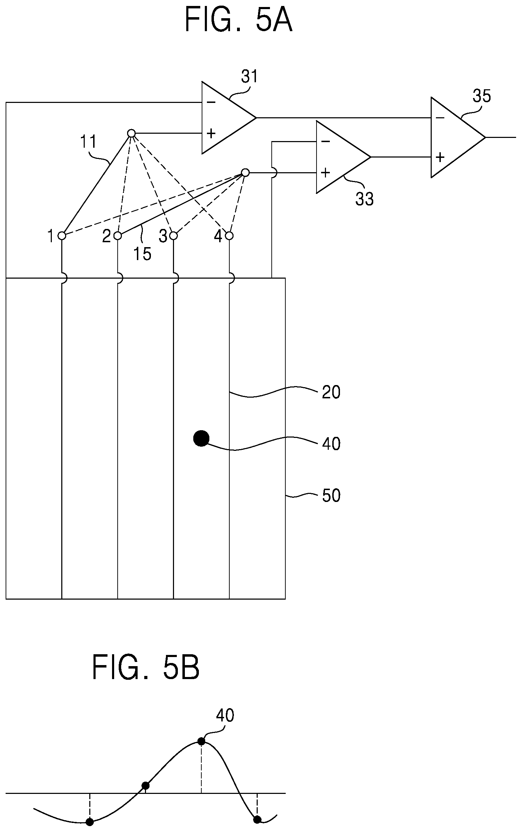

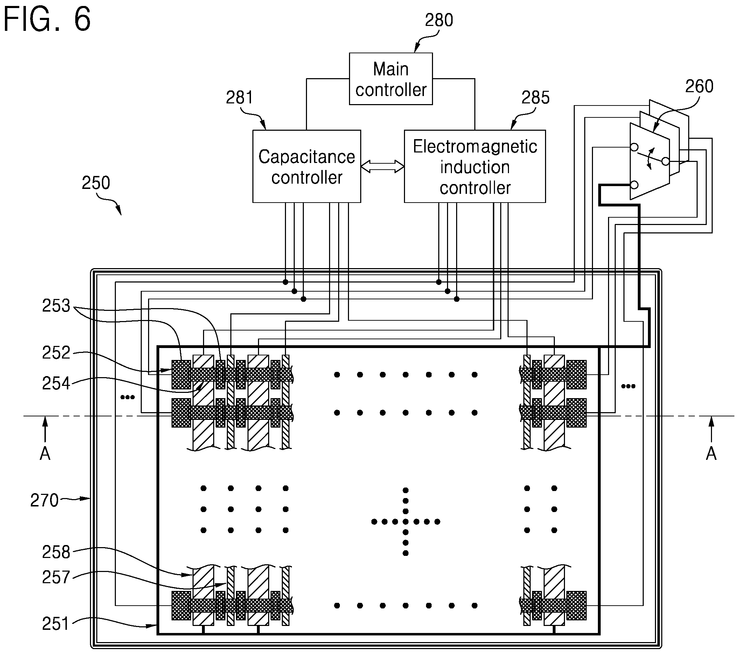

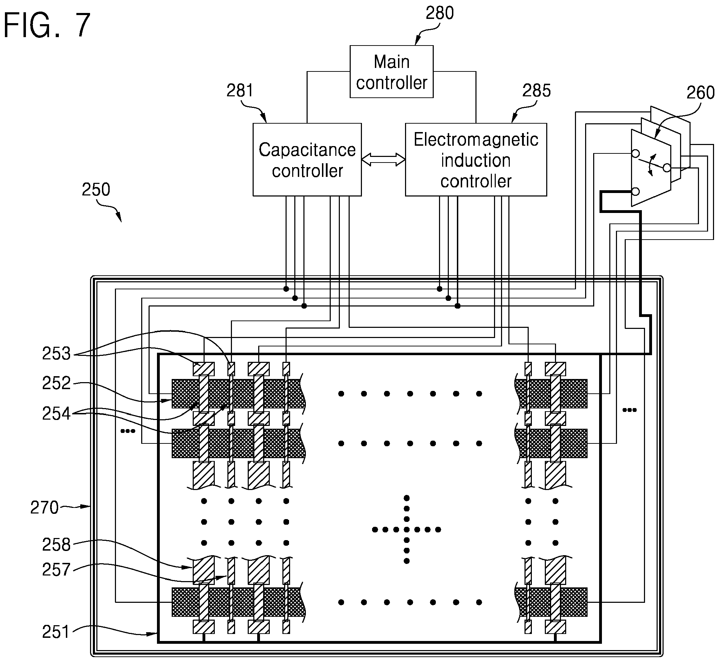

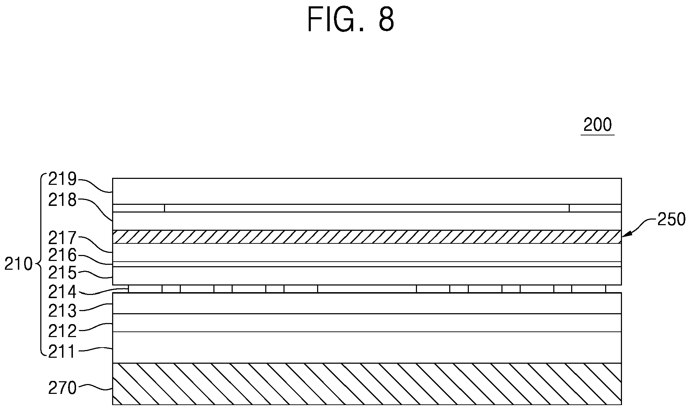

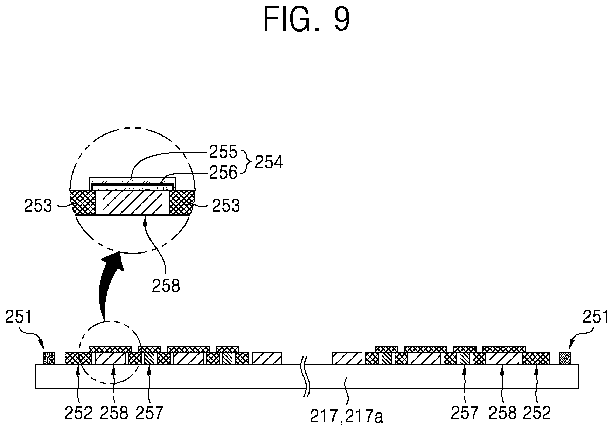

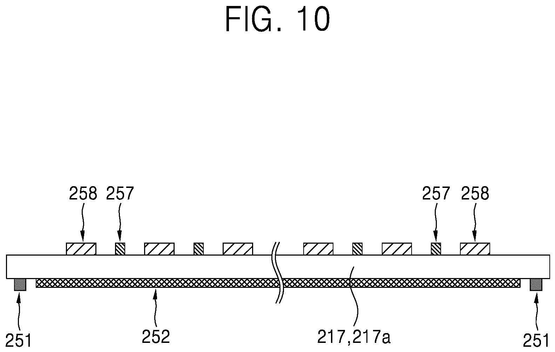

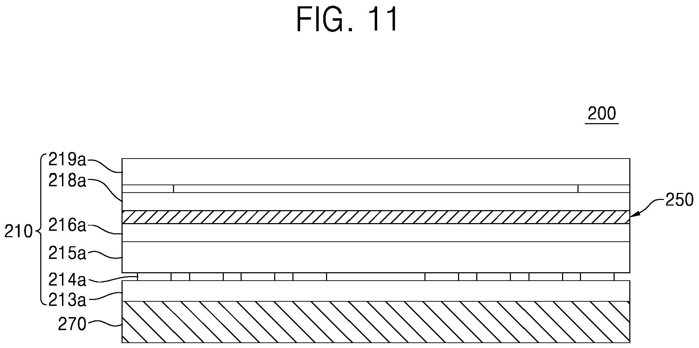

FIG. 1 is an exploded perspective view illustrating a display device according to a first embodiment of the present invention, FIGS. 2A and 2B are schematic views for describing detecting a touch location using a capacitance method, FIG. 3 is a schematic view for describing detecting a location of an electronic pen using an electromagnetic induction method, FIGS. 4A and 4B are schematic views for describing detecting a location of an electronic pen using an electromagnetic induction method according to an embodiment when a plurality of line antennas is provided, FIGS. 5A and 5B are schematic views for describing detecting a location of an electronic pen using an electromagnetic induction method according to another embodiment when a plurality of line antennas is provided, FIGS. 6 and 7 are plan views illustrating a structure of a location detecting unit according to a first embodiment of the present invention, FIG. 8 is a cross-sectional view illustrating a display module in which the location detecting unit is integrally provided in an LCD according to the first embodiment of the present invention, FIGS. 9 and 10 are cross-sectional views illustrating the location detecting unit which is formed on a filter glass substrate of the LCD according to the first embodiment of the present invention, as cross-sectional views taken along line A-A, and FIG. 11 is a cross-sectional view illustrating a display module in which the location detecting unit is integrally provided in an OLED according to the first embodiment of the present invention.

Referring to FIG. 1, a display device according to a first embodiment of the present invention includes a case frame 100, an image display unit 100 which is embedded in the case frame 100 to detect a touch location due to a touch operation and a location of an electronic pen while displaying an image, and a window glass 300 disposed on a front surface of the case frame 100.

In addition, the display module 200 and the window glass 300 are sequentially stacked to be coupled to the case frame 100.

The display module 200 according to the embodiment includes a display device 210 that visually displays an image, and a location detecting unit 250 which is integrally provided in the display device 210 and detects a touch location from a change in capacitance due to a touch operation and detects a location of an electronic pen from a change in inductive electromagnetic field due to electromagnetic induction.

That is, in the display module 200 according to the embodiment, the location detecting unit 250 is integrally provided in the display device 210 to form one unit module.

In the embodiment, the display device 210 serves to display the image to a user and may be various display devices including an organic light emitting diode (OLED), a liquid crystal display (LCD), an active matrix organic light emitting diode (AMOLED), a field emission display (FED), and the like. In addition, in the embodiment, the display device 210 includes both flat and curved types.

Since the display module 200 according to the embodiment includes the location detecting unit 250 that detects the touch location using a capacitance method and the location of the electronic pen using an electromagnetic induction method, before describing the display module 200 according to the embodiment, a method of detecting the touch location using a capacitance method and the location of the electronic pen using an electromagnetic induction method will be described schematically.

First, referring to FIGS. 2A and 2B, a method of detecting the touch location using a capacitance method will be described below.

A signal input pattern Tx provided to input a signal to the display module 200 is arranged and a signal sensing pattern Rx may be arranged in a direction crossing the signal input pattern Tx.

Referring to FIG. 2A, the signal input pattern Tx and the signal sensing pattern Rx are closely disposed, cross each other and are electrically insulated from each other.

In addition, when a pulse signal 50 by an AC voltage is input to the signal input pattern Tx, a predetermined range of charges is accumulated in the signal sensing pattern Rx which is disposed close to the signal input pattern Tx (see X of FIG. 2B).

At this time, when a finger or the like approaches the signal sensing pattern Rx, an amount of charges accumulated in the signal sensing pattern Rx is changed by the finger or the like (see Y in FIG. 2B) and a location of the finger may be detected by sensing a change in charge amount.

In addition, a method of detecting a location of an electronic pen using an electromagnetic induction method will be described below with reference to FIGS. 3 to 5B.

Referring to FIG. 3, when a line antenna 20 is connected to a closed loop 50 and the electronic pen 60 approaches the line antenna 20 side, an inductive voltage is generated in the line antenna 20 by the electronic pen 60.

In this case, a resonant circuit connected to a coil L2 and a capacitor C2 is provided in the electronic pen 60, and although not illustrated, a coil L1 and a capacitor C1 are connected to a power coil (not illustrated) that is provided separately outside the closed loop 50 to supply energy to the electronic pen 60.

Accordingly, when the electronic pen 60 approaches a location close to the line antenna 20, LC resonance (L1 * C1 = L2 * C2) is generated and energy is transmitted from the electronic pen 60 to the line antenna 20 to generate an inductive voltage.

In addition, as illustrated in FIG. 3, induction currents i1 and i2 flow along the line antenna 20 by the inductive voltage, and herein, when the electronic pen 60 is located at the center of the line antenna 20, the induced current i1 and the induced current i2 flowing through the closed loop 50 are the same in magnitude.

In addition, when the electronic pen 60 is located at the left side of the line antenna 20, the induced current i1 has a value larger than the induced current i2, and when the electronic pen 60 is located at the right side of the line antenna 20, the current i2 has a value larger than the induced current i1.

FIGS. 4A and 4B are a view for describing the location detection of the electronic pen using the electromagnetic induction method according to the embodiment, and illustrates changes in magnitude and phase of the voltage output from a plurality of line antennas 20 when the plurality of line antennas 20 is provided.

Herein, FIG. 4A illustrates the arrangement of the plurality of line antennas 20, a switch 10, and a differential amplifier 30 and FIG. 4B illustrates magnitudes and phases of the voltage output from the plurality of line antennas 20.

Referring to FIG. 4A, assuming that the electronic pen 60 is located on the relatively right side from the center, when the switch 10 is in the first location, as illustrated in FIG. 4B, the switch 10 has a relatively low voltage value, but as the switch 10 moves to the right side, that is, the switch 10 moves from the first location to the fourth location, the voltage value increases in a positive (+) direction and then decreases again and has a value of 0[V] at a point 40 where the electromagnetic pen 60 is located, and increases in a negative (-) direction in the switch 10 at the fourth location which is located at the right side from the point 40 where the electromagnetic pen 60 is located.

That is, when the plurality of line antennas 20 is disposed and the plurality of line antennas 20 are sequentially scanned through the switch 10, the magnitude and the phase of the voltage is changed according to the location of the electronic pen 60. In this case, the location of the electronic pen 60 corresponds to the point where the voltage value is 0[V].

FIGS. 5A and 5B are a view for describing the location detection of the electronic pen using the electromagnetic induction method according to another embodiment, and illustrates changes in magnitude and phase of the voltage output from two adjacent line antennas 20 among the plurality of line antennas 20 when the plurality of line antennas 20 is provided.

Herein, FIG. 5A illustrates the arrangement of the plurality of line antennas 20, the first and second switches 11 and 15, and the first to third differential amplifiers 31, 33 and 35 and FIG. 5B illustrates differences of magnitudes and phases of the voltages output from the two adjacent line antennas 20 among the plurality of line antennas 20.

For example, FIG. 5B illustrates a value obtained by subtracting the magnitude and the phase of the voltage from the second differential amplifier 33 when the second switch 15 is at the second location from the magnitude and the phase of the voltage output from the first differential amplifier 31 when the first switch 11 is at the first location, as a value output from the third differential amplifier 35.

Referring to FIG. 5B, the magnitude and the phase output from the third differential amplifier 35 have maximum values at the point 40 where the electronic pen 60 is located. This may be confirmed from the magnitude and the phase output from the differential amplifier 30 at the first and fourth locations of the switch 10 in FIG. 4B.

Further, as illustrated in FIG. 5A, a method of obtaining a location of the electronic pen 60 by using the differences in magnitude and phase of the voltages output from the two adjacent line antennas 20 may offset noise generated from the two adjacent line antennas 20, and thus, there is an advantage of more accurately finding the location of the electronic pen 60.

Meanwhile, in the embodiment, the location of the electronic pen 60 may be detected using the magnitudes and the phases of the voltages output from the two line antennas 20, but by extending this, the location of the electronic pen 60 may be detected using the magnitudes and the phases of the voltages output from at least two line antennas.

As described above, in the display module 200 according to the embodiment, the location detecting unit 250 capable of detecting the touch location using the capacitance method and the location of the electronic pen using the electromagnetic induction method, is integrally provided in the display device 210 to form one unit module.

Referring to FIGS. 6 and 7, the location detecting unit 250 capable of detecting the touch location using the capacitance method and the location of the electronic pen using the electromagnetic induction method according to the first embodiment of the present invention will be described below.

The location detecting unit 250 according to the embodiment includes a base loop 251, a plurality of first conductive patterns 252 which is elongated in a first direction and parallel to each other in a second direction crossing the first direction, a plurality of second conductive patterns 257 which is elongated in the second direction and parallel to each other in the first direction, and a plurality of third conductive patterns 258 which is elongated in the second direction, connected to the base loop 251, and parallel to each other in the first direction.

Herein, the first direction is a width direction of the case frame 100 and the second direction is a length direction of the case frame 100, but the directions may be defined reversely. In addition, one ends of the third conductive patterns 258 (particularly, an upper end of the third conductive pattern 252 illustrated in FIGS. 6 and 7) are maintained to be connected to a controller 285 to be described below or set to be open state, or a predetermined voltage may be applied or grounded. The other end of the third conductive pattern 258 (particularly, a lower end of the third conductive pattern 252 illustrated in FIGS. 6 and 7) may be connected to the base loop 251.

The base loop 251 is disposed to surround at least a part of a sensing area. Herein, the sensing area refers to an area where a user approaches or touches a finger to enable a capacitive touch input, and approaches or touches an electromagnetic pen that emits an electromagnetic force to enable an induced electromagnetic field input.

The sensing area may be the entire surface of the display device 210 and in the embodiment, the sensing area coincides with an area surrounded by the base loop 251 in order to minimize a bezel width of the case frame 100.

In addition, the first conductive patterns 252, the second conductive patterns 257 and the third conductive patterns 258 are disposed inside the sensing area and inside the base loop 251.

Further, the first conductive patterns 252, the second conductive patterns 257 and the third conductive patterns 258 are insulated from each other.

Meanwhile, the location detecting unit 250 according to the embodiment needs to detect the touch location from the capacitance change due to the touch operation and the location of the electronic pen from the change of the induced electromagnetic field due to the electromagnetic induction.

To this end, the first conductive patterns 252 and the second conductive patterns 257 make pairs to detect touch location from the capacitance change due to the touch operation, and the first conductive patterns 252 and the third conductive patterns 257 make pairs to detect the location of the electronic pen from the change of the induced electromagnetic field.

Particularly, in this embodiment, the first conductive patterns 252 are commonly used for detecting the touch location using the capacitance method and the location of the electronic pen using the electromagnetic induction method.

To this end, as illustrated in FIGS. 6 and 7, a multiplexer 260 which is a switching element is provided at one side of the location detecting unit 250.

The multiplexer 260 may be a 2:1 MUX 260 and the 2:1 MUX 260 has two inputs and one output.

The 2:1 MUXs 260 are disposed in a number corresponding to the number of the first conductive patterns 252, one end of the first conductive pattern 252 (particularly, the left end of the first conductive pattern 252 illustrated in FIGS. 6 and 7) is connected to one input of the 2:1 MUX 260 and the base loop 251 is connected to the other input, and the other end of the first conductive pattern 252 (particularly, the right end of the first conductive pattern 252 illustrated in FIGS. 6 and 7) is connected to the output.

In addition, the 2:1 MUX 260 is controlled by a capacitance controller 281 or an electromagnetic induction controller 285 to be described below.

In a capacitance sensing mode of detecting the touch location due to the touch operation, when the capacitance controller 281 is activated, the 2:1 MUX 260 connects one ends and the other ends of the first conductive patterns 252 to each other.

In addition, the capacitance controller 281 applies a signal (e.g., the signal input pattern Tx illustrated in FIGS. 2A and 2B) to one ends and the other ends of the first conductive patterns 252 and senses a signal (e.g., the signal sensing pattern Rx illustrated in FIGS. 2A and 2B) shown in the second conductive patterns 257 to detect the touch location from the capacitance change due to the touch operation. Alternatively, the capacitance controller 281 applies the signal (e.g., the signal input pattern Tx illustrated in FIGS. 2A and 2B) to one ends (particularly, the upper end of the second conductive pattern 257 illustrated in FIGS. 6 and 7) and the other ends (particularly, the lower end of the second conductive pattern 257 illustrated in FIGS. 6 and 7) of the second conductive patterns 257 and senses the signal shown in the first second conductive patterns 252 to detect the touch location from the capacitance change due to the touch operation.

Meanwhile, the 2:1 MUX 260 applies the signal (e.g., the signal input pattern Tx illustrated in FIGS. 2A and 2B) to any one of one ends and the other ends of the first conductive patterns 252 while one ends and the other ends of the first conductive patterns 252 are disconnected from each other and senses the signal (e.g., the signal sensing pattern Rx illustrated in FIGS. 2A and 2B) shown in the second conductive patterns 257 to detect the touch location from the capacitance change due to the touch operation. Alternatively, the 2:1 MUX 260 applies the signal (e.g., the signal input pattern Tx illustrated in FIGS. 2A and 2B) to any one of one ends and the other ends of the second conductive patterns 257 and senses the signal (e.g., the signal sensing pattern Rx illustrated in FIGS. 2A and 2B) shown in the first conductive patterns 252 to detect the touch location from the capacitance change due to the touch operation.

Meanwhile, although not illustrated, the multiplexer may be an N:1 MUX (not illustrated) and the N:1 MUX has N inputs and one output. The other ends of the first conductive patterns 252 are connected to the N inputs of the N:1 MUX and the base loop 252 is connected to the output.

As such, when the multiplexer is configured by the N:1 MUX, while the first conductive patterns 252 are disconnected from the base loop 251, the capacitance controller 281 applies the signal (e.g., the signal input pattern Tx illustrated in FIGS. 2A and 2B) to any one of one ends and the other ends of the first conductive patterns 252 and senses the signal (e.g., the signal sensing pattern Rx illustrated in FIGS. 2A and 2B) shown in the second conductive patterns 257 to detect the touch location from the capacitance change due to the touch operation. Alternatively, the capacitance controller 281 applies the signal (e.g., the signal input pattern Tx illustrated in FIGS. 2A and 2B) to any one of one ends and the other ends of the second conductive patterns 257 and senses the signal (e.g., the signal sensing pattern Rx illustrated in FIGS. 2A and 2B) shown in the first conductive patterns 252 to detect the touch location from the capacitance change due to the touch operation.

As such, the first conductive patterns 252 and the second conductive patterns 257 make pairs to be used for detecting the touch location from the capacitance change due to the touch operation as illustrated in FIG. 3 described above.

In addition, in an electromagnetic induction mode of detecting the location of the electronic pen from the change in induced electromagnetic field, when the electromagnetic induction controller 285 is activated, the 2:1 MUX 260 connects the other ends of the first conductive patterns 252 with the base loop 251.

In addition, the electromagnetic induction controller 285 compares the voltage of the base loop 251 with the inductive voltage output from one ends of the first conductive patterns 252 to detect the location of the electronic pen (the location of the induced electric field transmitted from the resonance circuit) in the second direction (see FIGS. 4A and 4B) or detect the location of the electronic pen in the second direction based on the signal output from one end of the two adjacent first conductive patterns 252 (particularly, by comparing a difference of the inductive voltage) (see FIGS. 5A and 5B). Further, the electromagnetic induction controller 285 compares the voltage of the base loop 251 with the inductive voltage output from one ends of the third conductive patterns 258 to detect the location of the electronic pen (the location of the induced electric field transmitted from the resonance circuit) in the first direction (see FIGS. 4A and 4B) or detect the location of the electronic pen in the first direction based on the signal output from one end of the two adjacent third conductive patterns 258 (particularly, by comparing a difference of the inductive voltage) (see FIGS. 5A and 5B).

Meanwhile, although not illustrated, when the multiplexer is the N:1 MUX (not illustrated), the N:1 MUX detects a transmission location of the induced electromagnetic field in the second direction based on the voltage of the base loop 251 and the voltage output from one end of the selected first conductive pattern 252 while the other ends of the first conductive patterns 252 are connected with the base loop 251 (see FIGS. 4A and 4B) or may detect the location of the electronic pen in the second direction based on the signal output from one ends of the two adjacent first conductive patterns 252 (particularly, by comparing the difference of the induced voltage) (see FIGS. 5A and 5B). Further, the N:1 MUX detects a transmission location of the induced electromagnetic field in the first direction based on the voltage of the base loop 251 and the inductive voltage output from one end of the selected third conductive pattern 252 connected with the base loop 251 (see FIGS. 4A and 4B) or may detect the location of the electronic pen in the first direction based on the signal output from one ends of the two adjacent third conductive patterns 252 (particularly, by comparing the difference of the induced voltage) (see FIGS. 5A and 5B).

As such, the first conductive patterns 252 and the third conductive patterns 257 make pairs to be used for detecting the location of the electronic pen from the change in the induced electromagnetic field as illustrated in FIGS. 3 to 5B described above.

Meanwhile, a structure in which the location detecting unit 250 according to the embodiment is integrally provided in the display device 210 will be described below.

For example, as illustrated in FIG. 8, when the display device 210 is the LCD, a structure of the display module 200 in which the display device 210 and the location detecting unit 250 are integrated will be described below.

The LCD is formed by sequentially stacking respective constituent elements including a bottom polarizer 212 on a backlight unit 211, a TFT glass substrate 213 on which a thin film transistor (TFT) 214, a liquid crystal layer 215, a filter glass substrate 217 in which a color filter 216 is deposited on the rear surface, a top polarizer 218, a cover glass 219, and the like.

In this case, in order to minimize the thickness of the display module 200, the location detecting unit 250 according to the embodiment may be integrally formed on the upper surface of the filter glass substrate 217 as illustrated in FIG. 8.

Particularly, as illustrated in FIG. 9, the first conductive patterns 252, the second conductive patterns 257, and the third conductive patterns 259 may be formed to be sequentially deposited on the upper surface of the filter glass substrate 217.

That is, the second conductive patterns 257 and the third conductive patterns 258 are alternately formed on the upper surface of the filter glass substrate 217 in parallel in the first direction, and as illustrated in FIGS. 6 and 9, the first conductive patterns 252 are formed on the upper surface of the filter glass substrate 217 by connecting a plurality of unit conductive patterns 253 formed in the first direction between the plurality of second conductive patterns 257 and third conductive patterns 258 with a bridge 254.

Herein, the bridge 254 is connected to a wire 256 so that the plurality of unit conductive patterns 253 spaced apart from each other to maintain a state in which the first conductive patterns 252, the second conductive patterns 257 and the third conductive patterns are insulated from each other electrically communicate with each other and the outside of the wire 256 is covered by an insulator 255. As such, the plurality of unit conductive patterns 253 are connected to each other with the bridge 254 to form the first conductive patterns 253.

Meanwhile, a plurality of first conductive patterns 252 are formed on the upper surface of the filter glass substrate 217 in parallel in the second direction, and as illustrated in FIG. 7, the second conductive patterns 257 and the third conductive patterns 258 may be formed by connecting the plurality of unit conductive patterns 253 formed between the plurality of first conductive patterns 252 in the second direction with the bridge 254.

In addition, the base loop 251 is formed at the upper edge of the filter glass substrate 217 to be spaced apart from the first conductive patterns 252, the second conductive patterns 257 and the third conductive patterns 258 and disposed to cover the first conductive patterns 252, the second conductive patterns 257 and the third conductive patterns 258.

Further, in FIG. 9, it is illustrated that the base loop 251 is disposed at the upper edge of the filter glass substrate 217, but is not limited thereto and may be disposed at the lower edge of the filter glass substrate 217.

Further, the first conductive patterns 252, the second conductive patterns 257, and the third conductive patterns 258 may be formed on one surface and the other surface of the filter glass substrate 217.

Particularly, as illustrated in FIG. 10, a plurality of second conductive patterns 257 and third conductive patterns 258 are alternately formed on the upper surface of the filter glass substrate 217 in the first direction in parallel and a plurality of first conductive patterns 252 may be formed on the lower surface of the filter glass substrate 217 in the second direction in parallel.

As described above, when the first conductive patterns 252 are formed on the lower surface of the filter glass substrate 217 and the second conductive patterns 257 and the third conductive patterns 258 are formed on the upper surface of the filter glass substrate 217, the bridge 254 illustrated in FIG. 9 needs not to be used.

In addition, the base loop 251 is formed at the upper edge or the lower edge of the filter glass substrate 217 to be spaced apart from the first conductive patterns 252, the second conductive patterns 257 and the third conductive patterns 258 and disposed to cover the first conductive patterns 252, the second conductive patterns 257 and the third conductive patterns 258.

Further, in FIGS. 9 and 10, the base loop 251 is formed on the upper surface or the lower surface of the filter glass substrate 217, but is not limited thereto, and the base loop 251 may be disposed at any place of the respective constituent elements configuring the LCD having the stacked structure illustrated in FIG. 8 and particularly, may be formed on the bottom of the backlight unit 211.

Meanwhile, in FIGS. 8 to 10, it is illustrated that the first conductive patterns 252, the second conductive patterns 257, the third conductive patterns 258, and the base loop 251 are formed on the upper surface or the lower surface of the filter glass substrate 217, and the embodiment is not limited thereto. The first conductive patterns 252, the second conductive patterns 257, the third conductive patterns 258, and the base loop 251 may be formed on one surface or the other surface of any one of the respective constituent elements including the backlight unit 211, the bottom polarizer 212, the TFT glass substrate 213, the filter glass substrate 217, the top polarizer 218, the cover glass 219, and the like which configure the LCD device having the stacked structure illustrated in FIG. 8.

Further, the first conductive patterns 252, the second conductive patterns 257, the third conductive patterns 258, and the base loop 251 may be disposed on the bottom of the display module 200 according to the embodiment.

In addition, the base loop 251 is formed to be spaced apart from the patterns of at least one of the first conductive patterns 252, the second conductive patterns 257 and the third conductive patterns 258.

Further, for example, as illustrated in FIG. 11, when the display device is the OLED, a structure of the display module 200 in which the display device 210 and the location detecting unit 250 are integrated will be described below.

As illustrated in FIG. 11, the OLED is formed by sequentially stacking respective constituent elements including a TFT glass substrate 213a deposited with a TFT 214a, an organic EL layer 215a, a polarizer 218a, a cover glass 219a, and the like.

In this case, in order to minimize the thickness of the display module 200, the location detecting unit 250 according to the embodiment may be stacked between the organic EL layer 215a and the polarizer 218a to be integrally formed.

Particularly, as illustrated in FIG. 9, a glass substrate 217a is stacked between the organic EL layer 215a and the polarizer 218a, and the first conductive patterns 252, the second conductive patterns 257, and the third conductive patterns 259 may be formed to be sequentially deposited on the upper surface of the glass substrate 217a.

That is, the second conductive patterns 257 and the third conductive patterns 258 are alternately formed on the upper surface of the glass substrate 217a in parallel in the first direction, and the first conductive patterns 252 are formed on the upper surface of the glass substrate 217 by connecting a plurality of unit conductive patterns 253 formed in the first direction between the plurality of second conductive patterns 257 and third conductive patterns 258 with a bridge 254.

Herein, the bridge 254 is connected to a wire 256 so that the plurality of unit conductive patterns 253 spaced apart from each other to maintain a state in which the first conductive patterns 252, the second conductive patterns 257 and the third conductive patterns are insulated from each other electrically communicate with each other and the outside of the wire 256 is covered by an insulator 255. As such, the plurality of unit conductive patterns 253 are connected to each other with the bridge 254 to form the first conductive patterns 253.

Meanwhile, a plurality of first conductive patterns 252 are formed on the upper surface of the filter glass substrate 217 in parallel in the second direction, and as illustrated in FIG. 7, the second conductive patterns 257 and the third conductive patterns 258 may be formed by connecting the plurality of unit conductive patterns 253 formed between the plurality of first conductive patterns 252 in the second direction with the bridge 254.

In addition, the base loop 251 is formed at the upper edge of the glass substrate 217a to be spaced apart from the first conductive patterns 252, the second conductive patterns 257 and the third conductive patterns 258 and disposed to cover the first conductive patterns 252, the second conductive patterns 257 and the third conductive patterns 258.

Meanwhile, in FIG. 9, it is illustrated that the base loop 251 is disposed at the upper edge of the glass substrate 217a, but is not limited thereto and may be disposed at the lower edge of the glass substrate 217a.

Further, the first conductive patterns 252, the second conductive patterns 257, and the third conductive patterns 258 may be formed on one surface and the other surface of the glass substrate 217a.

Particularly, as illustrated in FIG. 10, a plurality of second conductive patterns 257 and third conductive patterns 258 are alternately formed on the upper surface of the glass substrate 217a in the first direction in parallel, and a plurality of first conductive patterns 252 may be formed on the lower surface of the glass substrate 217a in the second direction in parallel.

As described above, when the first conductive patterns 252 are formed on the lower surface of the glass substrate 217 and the second conductive patterns 257 and the third conductive patterns 258 are formed on the upper surface of the glass substrate 217a, the bridge 254 illustrated in FIG. 9 needs not to be used.

In addition, the base loop 251 is formed at the upper edge or the lower edge of the glass substrate 217a to be spaced apart from the first conductive patterns 252, the second conductive patterns 257 and the third conductive patterns 258 and disposed to cover the first conductive patterns 252, the second conductive patterns 257 and the third conductive patterns 258.

Further, in FIGS. 9 and 10, the base loop 251 is formed on the upper surface or the lower surface of the glass substrate 217a, but is not limited thereto, and the base loop 251 may be disposed at any place of the respective constituent elements configuring the OLED having the stacked structure illustrated in FIG. 11.

Meanwhile, in FIGS. 9 and 10, it is illustrated that the first conductive patterns 252, the second conductive patterns 257, the third conductive patterns 258, and the base loop 251 are formed on the upper surface or the lower surface of the glass substrate 217a, and the embodiment is not limited thereto. The first conductive patterns 252, the second conductive patterns 257, the third conductive patterns 258, and the base loop 251 may be formed on one surface or the other surface of any one of the respective constituent elements including the TFT glass substrate 213a, the polarizer 218a, the cover glass 219a, and the like which configure the OLED device having the stacked structure illustrated in FIG. 11. Further, the first conductive patterns 252, the second conductive patterns 257, the third conductive patterns 258, and the base loop 251 may be disposed on the bottom of the display module 200 according to the embodiment.

Further, the location detecting unit 250 according to the embodiment may detect the location of the electronic pen using the electromagnetic induction method.

The detecting of the location of the electronic pen using the electromagnetic induction method needs to be configured so that the electronic pen may emit electromagnetic force.

Accordingly, the electronic pen may be configured to provide a battery and emit electromagnetic force by the battery itself, but in the embodiment, even when the battery is not provided in the electronic pen, the electronic pen is configured to emit the electromagnetic force to supply the energy to the electronic pen.

As a result, the display module 200 according to the embodiment further includes an energy supply unit 270 which is integrally provided in the display device and supplies energy to the electronic pen by applying a frequency corresponding to the resonance frequency of the resonance circuit of the electronic pen.

In the energy supply to the electronic pen, it is preferred that the energy is supplied to the electronic pen before detecting the location of the electronic pen using the electromagnetic induction method.

The energy supply unit 270 includes a power coil 270 in a coil form, and a coil driver (not illustrated) for driving the power coil 270 by supplying AC voltage and current to the power coil 270.

The power coil 270 serves to supply the energy to the electronic pen including the resonance circuit using the induced electromagnetic field.

The AC voltage / current corresponding to the resonance frequency of the resonance circuit of the electronic pen is applied to the power coil 270. In addition, the power coil 270 may be disposed outside the sensing area, inside the sensing area, or outside and inside the sensing area.

In addition, the power coil 270 may be formed of a single pattern printed on the substrate in a coil form, or a plurality of substrates formed with the coil-shaped patterns may be configured to overlap with each other and connect to each other.

The power coil 270 may be disposed at a location spaced apart from the outside at a predetermined interval from the base loop 251 coinciding with the sensing area as illustrated in FIGS. 6 and 7.

Further, the power coil 270 may be stacked on the bottom of the backlight unit 211 as illustrated in FIG. 8 and may be stacked on the bottom of the TFT glass substrate 213a as illustrated in FIG. 11.

Further, although not illustrated, the power coil 270 may be integrally provided at the side of the display device 210 and stacked on the bottom of the backlight unit 211 or the TFT glass substrate 213a together with the base loop 251.

The electronic pen emits electromagnetic force while causing resonance due to an inductive current by the electromagnetic force generated from the power coil 270 and emits electromagnetic force which is gradually offset even though the electromagnetic force is removed from the power coil 270.

Meanwhile, the first conductive patterns 252 and the second conductive patterns 257 make pairs to be used for detecting a touch location from the capacitance change due to the touch operation, and the first conductive patterns 252 and the third conductive patterns 257 make pairs to be used for detecting the location of the electronic pen from the change in the induced electromagnetic field.

Accordingly, the display module 200 according to the first embodiment of the present invention further includes a capacitance controller 281 to control the detection of the touch location and the location of the electronic pen and an electromagnetic induction controller 285.

The capacitance controller 281 serves to detect the touch location from the capacitance change due to the touch operation of a finger and the like.

Referring to FIGS. 6 and 7, as described above, the capacitance controller 281 controls the 2:1 MUX 260 to connect one ends of the first conductive patterns 252 to the other ends of the first conductive patterns 252 or open the other ends of the first conductive patterns 252.

In addition, the capacitance controller 281 applies the signal (for example, the signal input pattern Tx in FIGS. 2A and 2B) to at least one of one ends and the other ends of the first conductive patterns 252 and senses a signal (for example, the signal sensing pattern Rx in FIGS. 2A and 2B) shown in the second conductive patterns 257 to detect the touch location from the capacitance change due to the touch operation.

In addition, the capacitance controller 281 applies the signal (for example, the signal input pattern Tx in FIGS. 2A and 2B) to at least one of one ends and the other ends of the second conductive patterns 257 and senses a signal (for example, the signal sensing pattern Rx in FIGS. 2A and 2B) shown in the first conductive patterns 252 to detect the touch location from the capacitance change due to the touch operation.

That is, the capacitance controller 281 identifies a location where a characteristic (for example, an amplitude or a frequency) of the RX signal to determine a cross point of the first conductive pattern 252 and the second conductive pattern 257 corresponding to the corresponding location as the touch location.

Further, as described above, the electromagnetic induction controller 285 controls the 2:1 MUX 260 to connect the other ends of the first conductive patterns 252 to the base loop 251 and detects a transmission location of the induced electromagnetic field in the second direction based on the voltage of the base loop 251 and the inductive voltage output from the one ends of the first conductive patterns 252. Herein, one ends of the first conductive patterns 252 are connected to the electromagnetic induction controller 285.

Particularly, the electromagnetic induction controller 285 connects the other ends of the plurality of first conductive patterns 252 to the base loop 251 and compares the voltage of the base loop 251 with the inductive voltage output from one ends of the first conductive patterns 252 to detect the location of the electronic pen in the second direction (the location of the induced electromagnetic field emitted from the resonance circuit) (see FIGS. 4A and 4B) or compares a difference of the inductive voltages output from one ends of the two adjacent first conductive patterns 252 to detect the location of the electronic pen in second direction (see FIGS. 5A and 5B).

In addition, the electromagnetic induction controller 285 compares the voltage of the base loop 251 with the inductive voltage output from one ends of the selected third conductive patterns 258 while the other ends of the third conductive patterns 258 are connected to the base loop 251 to detect the location of the electronic pen in the first direction (see FIGS. 4A and 4B) or compares a difference of the inductive voltages output from one ends of the two adjacent third conductive patterns 258 to detect the location of the electronic pen in first direction (see FIGS. 5A and 5B). Herein, one ends of the third conductive patterns 258 are connected to the electromagnetic induction controller 285.

Meanwhile, in the embodiment, it is described that the location of the electronic pen is detected by comparing differences of inductive voltages output from one ends of the two adjacent first conductive patterns 252 and one ends of the two adjacent third conductive patterns 258, but it is not limited thereto. Further, the location of the electronic pen may be detected by comparing differences of inductive voltages output from one ends of at least two first conductive patterns 252 and one ends of the third conductive patterns 258.

In addition, the display module 200 according to the first embodiment of the present invention further includes a main controller 280 to control independently the capacitance controller 281 and the electromagnetic induction controller 285. The capacitance controller 281 and the electromagnetic induction controller 285 are connected to the main controller 280 and selectively operated.

That is, the main controller 280 activates the capacitance controller 281 in the case of detecting the touch location and reversely, activates the electromagnetic induction controller 285 in the case of detecting the location of the electronic pen.

Since the capacitance controller 281 and the electromagnetic induction controller 285 commonly use the first conductive patterns 252, the respective operations do not overlap with each other and selectively operate.

Accordingly, the capacitance controller 281 and the electromagnetic induction controller 285 are connected to the main controller 280 to mutually transmit an occupancy rate and an occupancy time for the first conductive patterns 252.

Meanwhile, while the capacitance controller 281 is operating, the unused base loop 251 may be set to an open state, or a specific voltage may be applied or grounded. In the embodiment, the base loop 251 is opened.

Further, while capacitance controller 281 is operating, the unused third conductive patterns 258 are maintained to be connected to the electromagnetic induction controller 285 or may be set to an open state, or a specific voltage may be applied or grounded.

As described above, referring to FIGS. 6 and 7, the first conductive patterns 252 may be used to sense both the capacitance touch and the induced electromagnetic field input, and when the first direction is the width direction of the case frame 100 and the second direction is the length direction of the case frame 100, connection lines of the second conductive patterns 257 and the third conductive patterns 258 may be disposed in the length direction of the case frame 100 without increasing in the bezel width direction which is the side of the case frame 100, thereby minimizing the size of the bezel width for disposing the connection lines.

Next, a display device according to a second embodiment of the present invention will be described below.

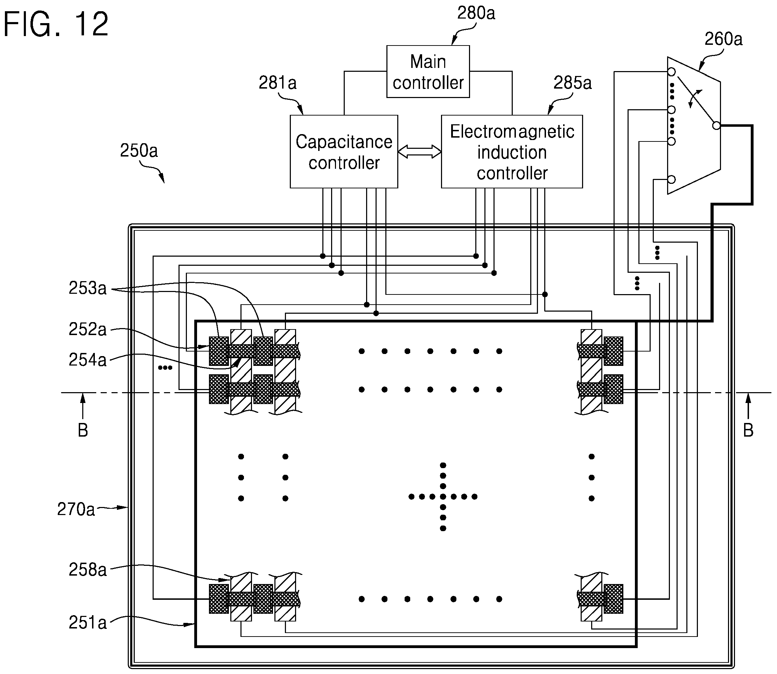

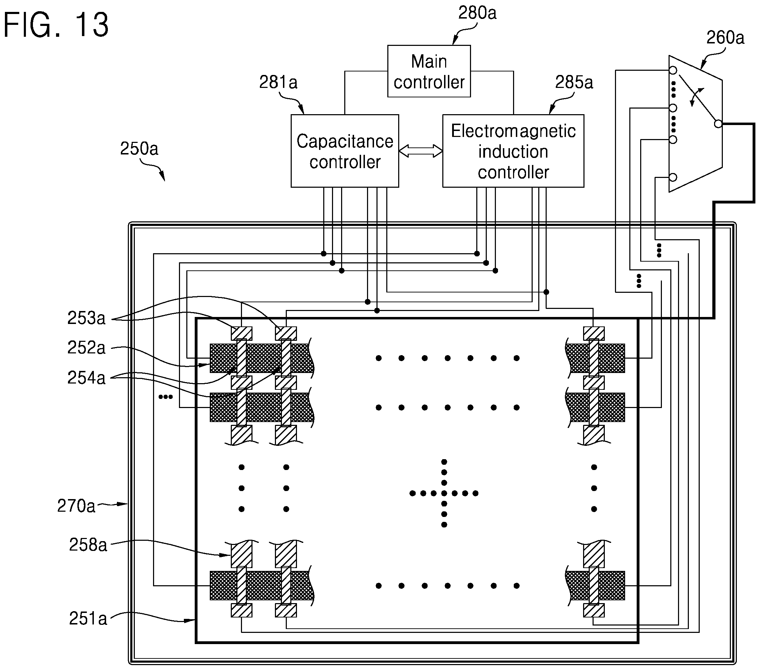

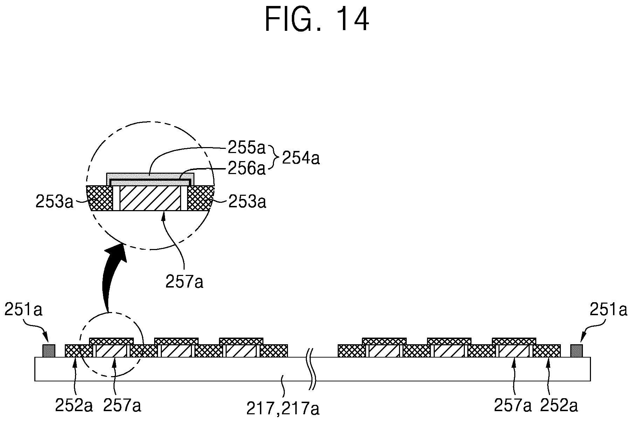

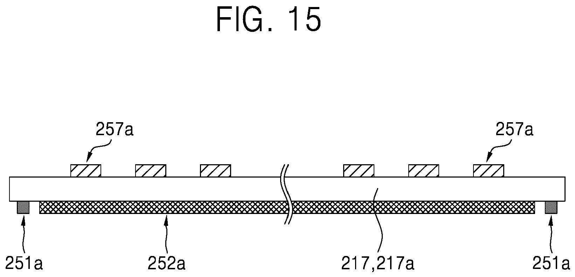

FIGS. 12 and 13 are plan views illustrating a structure of a location detecting unit according to a second embodiment of the present invention and FIGS. 14 and 15 are cross-sectional views illustrating the location detecting unit which is formed on a filter glass substrate of the LCD according to the first embodiment of the present invention, as cross-sectional views taken along line B-B.

A display device according to a second embodiment of the present invention includes a case frame (not illustrated), a display module (not illustrated) which is embedded in the case frame to detect a touch location due to a touch operation and a location of an electronic pen while displaying an image, and a window glass (not illustrated) disposed on a front surface of the case frame.

Since the case frame and the window glass according to the second embodiment of the present invention are the same as the case frame 100 and the window glass 300 according to the first embodiment of the present invention, the detailed description thereof will be omitted.

Hereinafter, the display module which is a difference from the first embodiment of the present invention will be described.

The display module according to the second embodiment of the present invention includes a display device that visually displays an image, and a location detecting unit 250a which is integrally provided in the display device and detects a touch location from a change in capacitance due to a touch operation and detects a location of an electronic pen from a change in inductive electromagnetic field due to electromagnetic induction.

In the display module according to the embodiment, the location detecting unit 250 is integrally provided in the display device to form one unit module.

In the embodiment, the display device serves to display the image to a user and may be various display devices including an organic light emitting diode (OLED), a liquid crystal display (LCD), an active matrix organic light emitting diode (AMOLED), a field emission display (FED), and the like. In addition, in the embodiment, the display device includes both flat and curved types.

In the embodiment, the location detecting unit 250a serves to detect the touch location from a change in capacitance due to the touch operation and the location of the electronic pen from a change in induced electromagnetic field generated when the electronic pen emitting electromagnetic force is approached.

The location detecting unit 250a according to the embodiment includes a base loop 251a, a plurality of first conductive patterns 252a which are elongated in a first direction and parallel to each other in a second direction crossing the first direction, a plurality of second conductive patterns 257a which are elongated in the second direction and parallel to each other in the first direction.

Herein, the first direction is a width direction of the case frame and the second direction is a length direction of the case frame, but the directions may be defined reversely.

The base loop 251 a is disposed to surround a sensing area. Herein, the sensing area refers to an area where a user approaches or touches a finger to enable a capacitive touch input, and approaches or touches an electromagnetic pen that emits an electromagnetic force to enable an induction electromagnetic field input.

The sensing area may be the entire surface of the display device and in the embodiment, the sensing area coincides with an area surrounded by the base loop 251a in order to minimize a bezel width of the case frame.

In addition, the first conductive patterns 252a and the second conductive patterns 257s are disposed inside the sensing area and inside the base loop 251a.

Further, the first conductive patterns 252a and the second conductive patterns 257a are insulated from each other.

Meanwhile, the location detecting unit 250a according to the embodiment needs to detect the touch location from the capacitance change due to the touch operation and the location of the electronic pen from the change in the induced electromagnetic field due to the electromagnetic induction.

To this end, the first conductive patterns 252a and the second conductive patterns 257a make pairs to be used for detecting the touch location from the capacitance change due to the touch operation and the location of the electronic pen from the change in the induced electromagnetic field due to the electromagnetic induction.

As illustrated in FIGS. 12 and 13, a multiplexer 260a which is a switching element is provided at one side of the location detecting unit 250a.

The multiplexer 260a may be an N:1 MUX 260a and the N:1 MUX 260a has N inputs and one output.

The other ends of the first conductive patterns 252a (particularly, the right end of the first conductive pattern 252a illustrated in FIGS. 12 and 13) and the other ends of the second conductive patterns 257a (particularly, the lower end of the second conductive pattern 257a illustrated in FIGS. 12 and 13) are connected to the N inputs of the N:1 MUX 260a and the base loop 251a is connected to the output.

The N:1 MUX 260a is controlled by a capacitance controller 281a or an electromagnetic induction controller 285a to be described below.

In a capacitance sensing mode for detecting the touch location due to the touch operation, when the capacitance controller 281a is activated, the N:1 MUX 260a disconnects the other ends of the first conductive patterns 252a and the second conductive patterns 257a from the base loop 251a.

In addition, the capacitance controller 281a applies a signal (for example, a signal input pattern Tx in FIGS. 2A and 2B) to at least one of one ends and the other ends of the first conductive patterns 252a in a state where the first conductive patterns 252a and the second conductive patterns 257a are disconnected from the base loop 251a and senses a signal shown in the second conductive pattern 257a (for example, a signal sensing pattern Rx in FIGS. 2A and 2B) to detect a touch location from the capacitance change due to the touch operation. Alternatively, the capacitance controller 281a applies a signal (for example, a signal input pattern Tx in FIGS. 2A and 2B) to at least one of one ends (particularly, the upper end of the second conductive pattern 257a illustrated in FIGS. 12 and 13) and the other ends of the second conductive patterns 257a and senses a signal shown in the first conductive patterns 252a (for example, a signal sensing pattern Rx in FIGS. 2A and 2B) to detect a touch location from the capacitance change due to the touch operation.

Further, although not illustrated, the multiplexer may be a 2:1 MUX and the 2:1 MUX has two inputs and one output.

The 2:1 MUX is arranged in a number corresponding to the number of the first conductive patterns 252a and the second conductive patterns 257a, and one end of the first conductive pattern 252a or the second conductive pattern 257a is connected to one input of the 2:1 MUX, the base loop 251a is connected to the other input, and the other end of the first conductive pattern 252a or the second conductive pattern 257a is connected to the output.

As such, when the multiplexer is configured by the 2:1 MUX, while the first conductive patterns 252a and the second conductive patterns 257a are disconnected to the base loop 251, the capacitance controller 281a applies the signal (e.g., the signal input pattern Tx illustrated in FIGS. 2A and 2B) to at least one of one ends and the other ends of the first conductive patterns 252 and senses the signal shown in the second conductive patterns 257 (e.g., the signal sensing pattern Rx illustrated in FIGS. 2A and 2B) to detect the touch location from the capacitance change due to the touch operation. Alternatively, the capacitance controller 281 applies the signal (e.g., the signal input pattern Tx illustrated in FIGS. 2A and 2B) to at least one of one ends and the other ends of the second conductive patterns 257 and senses the signal shown in the first conductive patterns 252 (e.g., the signal sensing pattern Rx illustrated in FIGS. 2A and 2B) to detect the touch location from the capacitance change due to the touch operation.

As such, the first conductive patterns 252a and the second conductive patterns 257a make pairs to be used for detecting the touch location from the capacitance change due to the touch operation as illustrated in FIG. 3 described above.

Further, in an electromagnetic induction mode of detection a location of an electronic pen from a change in induced electromagnetic field, when the electromagnetic induction controller 285a is activated, the electromagnetic induction controller 285a controls the N:1 MUX 260a to detect the location of the electronic pen (a transmission location of the induced electromagnetic field) in the second direction by comparing the voltage of the base loop 251a with the voltage output from one end of the first conductive pattern 252a while the other ends of the first conductive patterns 252a and the second conductive patterns 257a are connected with the base loop 251a (see FIGS. 4A and 4B) or may detect the location of the electronic pen in the second direction based on the signal output from one ends of the two adjacent first conductive patterns 252a (particularly, by comparing the difference of the induced voltage) (see FIGS. 5A and 5B). Further, the electromagnetic induction controller 285a may detect the location of the electronic pen in the first direction by comparing the voltage of the base loop 251a and the inductive voltage output from one end of the second conductive pattern 257a (see FIGS. 4A and 4B) or may detect the location of the electronic pen in the first direction based on the signal output from the other ends of the two adjacent second conductive patterns 257a (particularly, by comparing the difference of the induced voltage) (see FIGS. 5A and 5B).

Meanwhile, although not illustrated, when the multiplexer is the 2:1 MUX, the electromagnetic induction controller 285a controls the N:1 MUX 260a to detect a transmission location of the induced electromagnetic field in the second direction based on the voltage of the base loop 251a and the voltage output from one ends of the selected first conductive patterns 252a while the other ends of the first conductive patterns 252a and the second conductive patterns 257a are connected with the base loop 251a (see FIGS. 4A and 4B) or may detect the location of the electronic pen in the second direction based on the signal output from one ends of the two adjacent first conductive patterns 252 (particularly, by comparing the difference of the induced voltage) (see FIGS. 5A and 5B). Further, the electromagnetic induction controller 285a may detect the location of the electronic pen in the first direction based on the voltage of the base loop 251a and the voltage output from one ends of the selected second conductive patterns 257a connected to the base loop 251a (see FIGS. 4A and 4B) or may detect the location of the electronic pen in the first direction based on the signal output from the other ends of the two adjacent second conductive patterns 257a (particularly, by comparing the difference of the induced voltage) (see FIGS. 5A and 5B).

As such, the first conductive patterns 252a and the third conductive patterns 257a make pairs to be used for detecting the location of the electronic pen from the change in the induced electromagnetic field as illustrated in FIGS. 3 to 5B described above.

Meanwhile, a structure in which the location detecting unit 250a according to the embodiment is integrally provided in the display device will be described below.

For example, as illustrated in FIG. 8, when the display device is the LCD, a structure of the display module 200 in which the display device and the location detecting unit 250a are integrated will be described below.

In order to minimize the thickness of the display module, the location detecting unit 250a according to the embodiment may be integrally formed on the upper surface of the filter glass substrate 217.

Particularly, as illustrated in FIG. 14, the first conductive patterns 252a and the second conductive patterns 257a may be formed to be sequentially deposited on the upper surface of the filter glass substrate 217.

That is, the second conductive patterns 257a are alternately formed on the upper surface of the filter glass substrate 217 in parallel in the first direction, and as illustrated in FIGS. 12 and 14, the first conductive patterns 252a are formed on the upper surface of the filter glass substrate 217 by connecting a plurality of unit conductive patterns 253a formed in the first direction between the plurality of second conductive patterns 257a with a bridge 254a.

Herein, the bridge 254a is connected to a wire 256a so that the plurality of unit conductive patterns 253a spaced apart from each other to maintain a state in which the first conductive patterns 252a and the second conductive patterns 257a are insulated from each other electrically communicate with each other and the outside of the wire 256a is covered by an insulator 255a. As such, the plurality of unit conductive patterns 253a are connected to each other with the bridge 254a to form the first conductive patterns 253a.

Meanwhile, a plurality of first conductive patterns 252a are formed on the upper surface of the filter glass substrate 217a in parallel in the second direction, and as illustrated in FIG. 11, the second conductive patterns 257a may be formed by connecting the plurality of unit conductive patterns 253a formed between the plurality of first conductive patterns 252a in the second direction with the bridge 254a.

In addition, the base loop 251a is formed at the upper edge of the filter glass substrate 217 to be spaced apart from the first conductive patterns 252a and the second conductive patterns 257a and disposed to cover the first conductive patterns 252a and the second conductive patterns 257a.

Meanwhile, in FIG. 11, it is illustrated that the base loop 251a is disposed at the upper edge of the filter glass substrate 217, but is not limited thereto and may be disposed at the lower edge of the filter glass substrate 217.

Further, the first conductive patterns 252a and the second conductive patterns 257a may be formed on one surface and the other surface of the filter glass substrate 217.

Particularly, as illustrated in FIG. 15, a plurality of second conductive patterns 257a are alternately formed on the upper surface of the filter glass substrate 217 in the first direction in parallel and a plurality of first conductive patterns 252a may be formed on the lower surface of the filter glass substrate 217 in the second direction in parallel.

As described above, when the first conductive patterns 252a are formed on the lower surface of the filter glass substrate 217 and the second conductive patterns 257a and the third conductive patterns 258 are formed on the upper surface of the filter glass substrate 217, the bridge 254 illustrated in FIG. 14 needs not to be used.

In addition, the base loop 251 a is formed at the upper edge or the lower edge of the filter glass substrate 217 to be spaced apart from the first conductive patterns 252a and the second conductive patterns 257a and disposed to cover the first conductive patterns 252a and the second conductive patterns 257a.

Further, in FIGS. 14 and 15, the base loop 251a is formed on the upper surface or the lower surface of the filter glass substrate 217, but is not limited thereto, and the base loop 251a may be formed on the bottom of the backlight unit 211 illustrated in FIG. 8.

Meanwhile, in FIGS. 8, 14, and 15, it is illustrated that the first conductive patterns 252a, the second conductive patterns 257a, and the base loop 251a are formed on the upper surface or the lower surface of the filter glass substrate 217, and the embodiment is not limited thereto. The first conductive patterns 252a, the second conductive patterns 257a, and the base loop 251a may be formed on one surface or the other surface of any one of the respective constituent elements including the backlight unit 211, the bottom polarizer 212, the TFT glass substrate 213, the filter glass substrate 217, the top polarizer 218, the cover glass 219, and the like which configure the LCD device having the stacked structure illustrated in FIG. 8. Further, the first conductive patterns 252a, the second conductive patterns 257a, and the base loop 251a may be disposed on the bottom of the display module 200 according to the embodiment.

In addition, the base loop 251a is formed to be spaced apart from the patterns of at least one of the first conductive patterns 252a and the second conductive patterns 257a.

Further, in the case where the display device is the OLED, when describing the structure of the display module in which the display device and the locating detecting unit 250a are integrated, as illustrated in FIGS. 14 and 15, it is illustrated that the first conductive patterns 252a, the second conductive patterns 257a, and the base loop 251a are formed on the upper surface or the lower surface of the glass substrate 217a, and the embodiment is not limited thereto. The first conductive patterns 252a, the second conductive patterns 257a, and the base loop 251a may be formed on one surface or the other surface of any one of the respective constituent elements including the TFT glass substrate 213a, the polarizer 218a, the cover glass 219a, and the like which configure the OLED device having the stacked structure illustrated in FIG. 11. Further, the first conductive patterns 252a, the second conductive patterns 257a, and the base loop 251a may be disposed on the bottom of the display module according to the embodiment.

Hereinafter, when the display device is the OLED, the structure of the display module in which the display device and the locating detecting unit 250a are integrated refers to the structure of the display module according to the first embodiment of the present invention, and the detailed description thereof will be omitted.

Referring to FIGS. 12 and 13, the display module according to the embodiment further includes an energy supply unit 270a which is integrally provided in the display device and supplies energy to the electronic pen by applying a frequency corresponding to the resonance frequency of the resonance circuit of the electronic pen.

In addition, the energy supply unit 270a includes a power coil 270a in a coil form, and a coil driver (not illustrated) for driving the power coil 270a by supplying AC voltage and current to the power coil 270a.

Since the power coil 270a according to the embodiment is the same as the power coil 270 according to the first embodiment of the present invention, the detailed description thereof will be omitted.

Meanwhile, the location detecting unit 250a according to the embodiment detects the touch location from the capacitance change due to the touch operation and the location of the electronic pen from the change of the induced electromagnetic field due to the electromagnetic induction.

In this case, while the other ends of the first conductive patterns 252a and the other ends of the second conductive patterns 257a are disconnected from the base loop 251a, the first conductive patterns 252a and the second conductive patterns 257a make pairs to detect the touch location from the capacitance change due to the touch operation.

Further, while the first conductive patterns 252a and the other ends of the second conductive patterns 257a are connected with the base loop 251a, the first conductive patterns 252a and the second conductive patterns 257a make pairs to detect the location of the electronic pen from the change in the induced electromagnetic field generated when the electronic pen emitting electromagnetic force is approached.

Accordingly, the display module according to the second embodiment of the present invention further includes a capacitance controller 281a to control the detection of the touch location and the location of the electronic pen and an electromagnetic induction controller 285a.

Referring to FIGS. 12 and 13, the capacitance controller 281a controls an N:1 MUX 260a and applies a signal (for example, a signal input pattern Tx of FIGS. 2A and 2B) to at least one of one ends and the other ends of the first conductive patterns 252a while the first conductive patterns 252a and the other ends of the second conductive patterns 257a are disconnected from the base loop 251a and senses a signal shown in the second conductive patterns 257a (for example, a signal sensing pattern Rx of FIGS. 2A and 2B) to detect the touch location from the capacitance change due to the touch operation.

Further, the capacitance controller 281a applies the signal (for example, the signal input pattern Tx in FIGS. 2A and 2B) to at least one of one ends and the other ends of the second conductive patterns 257a and senses a signal (for example, the signal sensing pattern Rx in FIGS. 2A and 2B) shown in the first conductive patterns 252a to detect the touch location from the capacitance change due to the touch operation.

That is, the capacitance controller 281a identifies a location where a characteristic (for example, an amplitude or a frequency) of the RX signal to determine a cross point of the first conductive pattern 252a and the second conductive pattern 257a corresponding to the corresponding location as the touch location.

Meanwhile, the electromagnetic induction controller 285a controls the N:1 MUX 260a to detect a transmission location of the induced electromagnetic field in the second direction based on the voltage of the base loop 251a and the voltage output from one ends of the selected first conductive patterns 252a while the first conductive patterns 252a and the other ends of the second conductive patterns 257a are connected with the base loop 251a (see FIGS. 4A and 4B) or may detect the location of the electronic pen in the second direction by comparing the difference of the induced voltage output from one ends of the two adjacent first conductive patterns 252a (see FIGS. 5A and 5B). Further, one ends of the first conductive patterns 252a and the second conductive patterns 257s are connected to the electromagnetic induction controller 285a.

In addition, the electromagnetic induction controller 285a detects a transmission location of the induced electromagnetic field in the first direction based on the voltage of the base loop 251a and the voltage output from one ends of the selected second conductive patterns 252a (see FIGS. 4A and 4B) or may detect the location of the electronic pen in the first direction by comparing the difference of the induced voltage output from one ends of the two adjacent second conductive patterns 257a (see FIGS. 5A and 5B).

Meanwhile, in the embodiment, it is described that the location of the electronic pen is detected by comparing differences of inductive voltages output from one ends of the two adjacent first conductive patterns 252 and one ends of the two adjacent second conductive patterns 257a, but it is not limited thereto. Furthermore, the location of the electronic pen may be detected by comparing differences of inductive voltages output from one ends of at least two first conductive patterns 252a and one ends of the second conductive patterns 257a.

In addition, the display module according to the second embodiment of the present invention further includes a main controller 280a to control independently the capacitance controller 281a and the electromagnetic induction controller 285a. The capacitance controller 281a and the electromagnetic induction controller 285a are connected to the main controller 280a and selectively operated.

That is, the main controller 280a activates the capacitance controller 281a in the case of detecting the touch location and reversely, activates the electromagnetic induction controller 285a in the case of detecting the location of the electronic pen.

As described above, the present invention is not limited to the embodiments described herein, and it would be apparent to those skilled in the art that various changes and modifications might be made without departing from the spirit and the scope of the present invention. Therefore, it will be determined that the changed examples or modified examples are included in the appended claims of the present invention.

### [INDUSTRIAL APPLICABILITY]

The present invention may be applied to an information technology (IT) industry field.

## Claims

1. A display module capable of detecting a location using capacitance and electromagnetic induction methods, the display module comprising:
a display device; and
a location detecting unit which is integrally provided in the display device and detects a touch location from a change in capacitance due to a touch operation and detects a location of an electronic pen from a change in inductive electromagnetic field due to electromagnetic induction.

2. The display module of claim 1, wherein the location detecting unit includes
a base loop that surrounds at least a part of a sensing area;
a plurality of first conductive patterns which is elongated in a first direction in the sensing area and parallel to each other in a second direction crossing the first direction;
a plurality of second conductive patterns which are elongated in the second direction in the sensing area and parallel to each other in the first direction to detect a touch location from a capacitance change due to a touch operation by making pairs with the first conductive patterns; and
a plurality of third conductive patterns which are elongated in the second direction in the sensing area, connected to the base loop, and parallel to each other in the first direction to detect a location of the electronic pen from the change in the induced electromagnetic field generated as the electronic pen emitting electromagnetic force is approached by making pairs with the first conductive patterns.

3. The display module of claim 2, wherein the second conductive patterns and the third conductive patterns are formed on one surface of the substrate disposed in the display device in parallel in the first direction,
the first conductive patterns are formed on one surface of the substrate in parallel in the second direction and cross the second conductive patterns and the third conductive patterns, and
the first conductive patterns are formed on one surface of the substrate by connecting a plurality of unit conductive patterns formed in the first direction between the second conductive patterns and the third conductive patterns by a bridge, or the second conductive patterns and the third conductive patterns are formed on one surface of the substrate by connecting a plurality of unit conductive patterns formed between the first conductive patterns in the second direction by a bridge.

4. The display module of claim 2, wherein the second conductive patterns and the third conductive patterns are formed on one surface of the substrate disposed in the display device in parallel in the first direction, and
the first conductive patterns are formed on the other surface of the substrate in parallel in the second direction.

5. The display module of claim 2, wherein the first conductive patterns, the second conductive patterns, the third conductive patterns, and the base loop are formed on one surface or the other surface of at least one of a backlight unit a bottom polarizer, a TFT glass substrate, a filter glass substrate, a top polarizer, and a cover glass configuring a liquid crystal display (LCD) device or
formed on one surface or the other surface of at least one of a TFT glass substrate, a polarizer, and a cover glass configuring an organic light emitting diodes(OLED) device.

6. The display module of claim 2, further comprising:
a capacitance controller which connects one ends of the first conductive patterns to the other ends or opens the other ends of the first conductive patterns and applies a signal to at least one of one ends and the other ends of the first conductive patterns to detect the signal shown in the second conductive patterns, or connects one ends of the second conductive patterns to the other ends or opens the other ends of the second conductive patterns and applies a signal to at least one of one ends and the other ends of the second conductive patterns to detect the signal shown in the first conductive patterns, while the first conductive patterns and the second conductive patterns are disconnected from the base loop; and
an electromagnetic induction controller which detects a transmission location of an induced electromagnetic field in the second direction based on a signal output from one ends of the first conductive patterns and detects a transmission location of an induced electromagnetic field in the first direction based on a signal output from one ends of the third conductive patterns, while the first conductive patterns and the third conductive patterns are connected with the base loop,
wherein in the case of detecting the transmission location of the induced electromagnetic field, one ends of the first conductive patterns and the third conductive patterns are connected to the electromagnetic induction controller and the other ends thereof are connected to the base loop.

7. The display module of claim 6, wherein the electromagnetic induction controller detects a location of the electronic pen in the second direction based on the signal output from one ends of at least two first conductive patterns and detects the location of the electronic pen in the first direction based on the signal output from one ends of at least two third conductive patterns.

8. The display module of claim 1, wherein the location detecting unit includes
a base loop that surrounds at least a part of a sensing area;
a plurality of first conductive patterns which is elongated in a first direction in the sensing area and parallel to each other in a second direction crossing the first direction; and
a plurality of second conductive patterns which is elongated in a second direction in the sensing area and parallel to each other in the first direction,
wherein the first conductive patterns and the second conductive patterns make pairs to detect a touch location from a capacitance change due to a touch operation while the first conductive patterns and the second conductive patterns are disconnected from the base loop, and
the first conductive patterns and the second conductive patterns make pairs to detect the location of the electronic pen from a change in an induced electromagnetic field generated as the electronic pen emitting electromagnetic force is approached, while the first conductive patterns and the second conductive patterns are connected with the base loop.

9. The display module of claim 8, wherein the second conductive patterns are formed on one surface of the substrate disposed in the display device in parallel in the first direction,
the first conductive patterns are formed on one surface of the substrate in parallel in the second direction and cross the second conductive patterns, and
the first conductive patterns are formed on one surface of the substrate by connecting a plurality of unit conductive patterns formed in the first direction between the second conductive patterns by a bridge, or the second conductive patterns are formed on one surface of the substrate by connecting a plurality of unit conductive patterns formed between the first conductive patterns in the second direction by a bridge, so that the first conductive patterns and the second conductive patterns are insulated from each other.

10. The display module of claim 8, wherein the second conductive patterns are formed on the one surface of the substrate configuring the upper surface of the display device in parallel in the first direction, and
the first conductive patterns are formed on the other surface of the substrate in parallel in the second direction.

11. The display module of claim 8, wherein the first conductive patterns, the second conductive patterns, and the base loop are formed on one surface or the other surface of at least one of a backlight unit a bottom polarizer, a TFT glass substrate, a filter glass substrate, a top polarizer, and a cover glass configuring a liquid crystal display (LCD) device or
formed on one surface or the other surface of at least one of a TFT glass substrate, a polarizer, and a cover glass configuring an organic light emitting diodes(OLED) device.

12. The display module of claim 8, further comprising:
a capacitance controller which connects one ends of the first conductive patterns to the other ends or opens the other ends of the first conductive patterns and applies a signal to at least one of one ends and the other ends of the first conductive patterns to detect the signal shown in the second conductive patterns, or connects one ends of the second conductive patterns to the other ends or opens the other ends of the second conductive patterns and applies a signal to at least one of one ends and the other ends of the second conductive patterns to detect the signal shown in the first conductive patterns, while the first conductive patterns and the second conductive patterns are disconnected from the base loop; and
an electromagnetic induction controller which detects a transmission location of an induced electromagnetic field in the second direction based on a signal output from one ends of the first conductive patterns and detects a transmission location of an induced electromagnetic field in the first direction based on a signal output from one ends of the second conductive patterns, while the first conductive patterns and the second conductive patterns are connected with the base loop,
wherein in the case of detecting the transmission location of the induced electromagnetic field, one ends of the first conductive patterns and the second conductive patterns are connected to the electromagnetic induction controller and the other ends thereof are connected to the base loop.

13. The display module of claim 12, wherein the electromagnetic induction controller detects a location of the electronic pen in the second direction based on the signal output from one ends of at least two first conductive patterns and detects the location of the electronic pen in the first direction based on the signal output from one ends of at least two second conductive patterns.

14. The display module of claim 1, further comprising:
an energy supply unit which is integrally provided in the display device and supplies energy to the electronic pen by applying a frequency corresponding to a resonance frequency having a resonance circuit of the electronic pen.

15. The display module of claim 2 or 8, wherein the base loop is disposed at one edge or the other edge of the substrate disposed in the display device to surround at least a part of the sensing area.

16. A display device comprising:
a case frame; and
a display module of claim 1 which is embedded in the case frame, visually displays an image, and detects a touch location from a capacitance change due to a touch operation and a location of an electronic pen from a change in an induced electromagnetic field due to electromagnetic induction.
